Europäisches Patentamt

European Patent Office

Office européen des brevets

(11) Veröffentlichungsnummer: **0 278 916 B1**

## (12) EUROPÄISCHE PATENTSCHRIFT

(45) Veröffentlichungstag der Patentschrift: **09.09.92**

(51) Int. Cl.5: **H01H 13/70**, G09B 21/00

(21) Anmeldenummer: **88810085.6**

(22) Anmeldetag: **11.02.88**

(54) **Vorrichtung an elektronischen Tastaturen zur Ouittierung der Tastenbetätigung.**

(30) Priorität: **11.02.87 CH 520/87**

(43) Veröffentlichungstag der Anmeldung:
**17.08.88 Patentblatt 88/33**

(45) Bekanntmachung des Hinweises auf die
Patenterteilung:
**09.09.92 Patentblatt 92/37**

(84) Benannte Vertragsstaaten:
**AT BE FR GB IT LU NL SE**

(56) Entgegenhaltungen:
EP-A- 0 020 118
WO-A-83/03909
WO-A-86/03870

IBM TECHNICAL DISCLOSURE BULLETIN,
Band 23, Nr. 4, September 1980, Seiten
1727-1731, New York, US; R.G. HEATH:
"Braille display portable electronic calculator"

(73) Patentinhaber: **DYNALAB AG**
**Gewerbestrasse 10**
**CH-6330 Cham(CH)**

(72) Erfinder: **Schenk, Max**
**In den Bünten**
**CH-5634 Merenschwand(CH)**
Erfinder: **Schenk, Hans**
**Im Brand**
**CH-5637 Beinwil(CH)**

(74) Vertreter: **Blum, Rudolf Emil Ernst et al**
**c/o E. Blum & Co Patentanwälte Vorderberg**
**11**
**CH-8044 Zürich(CH)**

# Beschreibung

Die Erfindung betrifft eine Vorrichtung an elektronischen Tastaturen zur Quittierung von Tastenbetätigungen.

Insbesondere bei wegfreien, elektronischen Tastaturen ist für den Benutzer sicherzustellen, dass durch eine Tastenbetätigung auch wirklich das entsprechende Tastensignal ausgelöst worden ist. Hierzu ist es bekannt, bei jeder erfolgreichen Betätigung einen Signalton zu erzeugen. Dies ist besonders in Innenräumen für die Umgebung störend. Im Freien sind andererseits die Signaltöne oft kaum wahrnehmbar. Aufwendigere Systeme sehen deshalb einen fühlbarer, mechanischen Tastenanschlag vor, mittels welchem der Benutzer die erfolgreiche Tastenbetätigung taktil wahrnimmt. Solche Einrichtungen eignen sich indessen nicht für wegfreie Tastaturen. Ueberdies sind sie mechanisch aufwendig und störungsanfällig.

Es stellt sich deshalb die Aufgabe, eine Vorrichtung der eingangs erwähnten Art zu schaffen, bei welcher diese Nachteile nicht auftreten und die insbesondere auch geeignet ist für die Verwendung mit wegfreien Tastaturen.

Diese Aufgabe wird erfindungsgemäss gelöst durch mindestens eine elektrisch auslösbare Schlagvorrichtung, welche beim Auftreten eines Tastensignals auslösbar ist und mechanisch so mit dem Tastenbereich verbunden ist, dass der erzeugte mechanische Impuls auf die Tasten übertragen wird.

Vorzugsweise ist pro Tastatur nur eine solche Schlagvorrichtung vorgesehen, welche bei jedem Tastensignal auslösbar ist und den mechanischen Impuls auf die gesamte Tastatur überträgt. Der Benutzer nimmt diesen mechanischen Impuls mit dem Finger auf dem jeweils betätigten Tastenfeld wahr.

Diese Anordnung bietet den Vorteil, dass auf einfache Weise ein Anschlag simuliert wird, der einem herkömmlichen Schreibmaschinenanschlag gleicht. Der erzeugte Impuls wird sowohl akustisch als auch taktil wahrgenommen, wobei der erzeugte Ton etwa dem Anschlaggeräusch einer Schreibmaschine entspricht. Die taktile Wahrnehmung hat den Vorteil, dass auch im Freien und bei Lärm eine deutliche Quittierung der erfolgten Tastenbetätigung erfolgt.

Nachfolgend wird ein Ausführungsbeispiel der Erfindung anhand der Figuren näher erläutert. Es zeigen:

Fig. 1 eine perspektivische Explosionsansicht einer verwendbaren Folientastatur;

Fig. 2 einen schematischen Schnitt durch diese Tastatur mit der Schlageinrichtung; und

Fig. 3 ein Blockschaltbild der entsprechenden Schaltung.

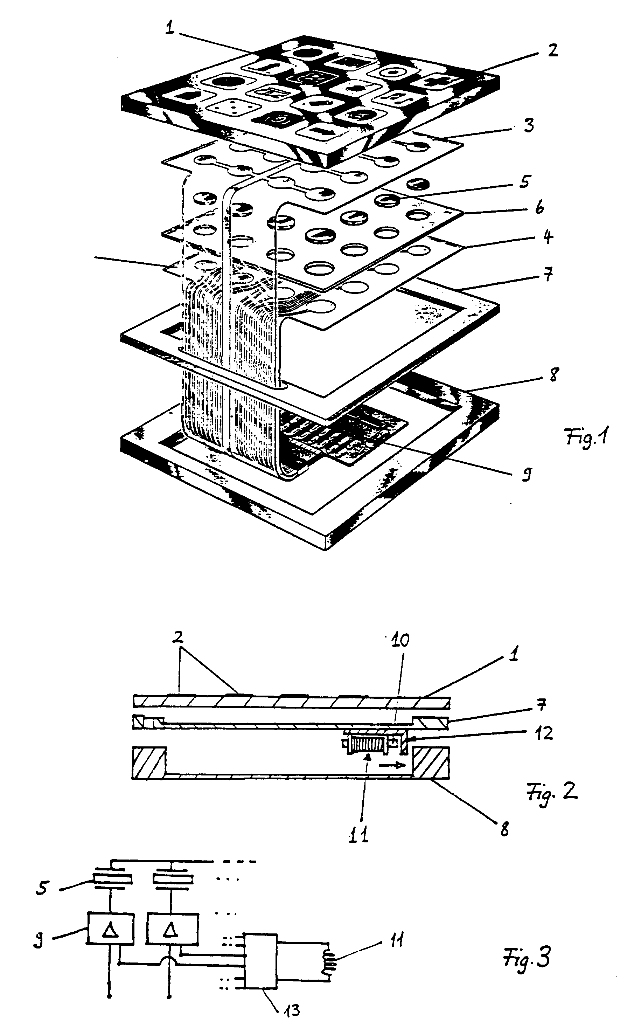

Die in Fig. 1 beispielsweise dargestellte Folientastatur besitzt eine steife Frontplatte 1, z.B. aus Metall, auf welcher Tastenfelder 2 angeordnet sind. Auf diese Tastenfelder ausgerichtet sind Kontaktfolien 3, 4, zwischen welchen pro Tastenfeld je ein Piezoelement 5 angeordnet und von einer Halteplatte 6 zentriert sind. Die Folientastatur ist von einem Gehäuse 7 eingeschlossen, an welches sich ein Aufnahmeteil 8 für die Interfaceschaltung 9 anschliesst. Frontplatte 1, Gehäuse 7 und Aufnahmeteil 8 sind mechanisch zu einer Einheit verbunden. Die Tastenbetätigung erfolgt wegfrei, indem die Kraft, welche auf ein Tastenfeld ausgeübt wird, ohne merkliche Verformung der Frontplatte 1 auf das jeweilige Piezoelement übertragen wird. Die dadurch zwischen den Oberflächen des Piezoelementes erzeugte Piezospannung wird über die Kontaktfolien abgegriffen und von der Interface-Schaltung 9 in bekannter Weise zu Signalen verarbeitet.

In Fig. 2, worin Teile der Folientastatur weggelassen sind, ist eine Schlagvorrichtung 10, 11, 12 ersichtlich, welche am Gehäuse 7 angeordnet und damit mechanisch mit der Frontplatte 1 verbunden ist.

Die Schlagvorrichtung besteht im vorliegenden Ausführungsbeispiel aus einer kleinen Spule 11, innerhalb welcher ein Kern 10 beweglich gelagert und z.B. mittels einer Feder (nicht dargestellten) gehalten ist. Der bewegliche Kern 10 wirkt als Schlagbolzen gegen einen Vorsprung 12, der am Gehäuse befestigt ist. Er kann selbstverständlich auch direkt auf das Gehäuse wirken. Wesentlich ist dabei die mechanische Verbindung zur Frontplatte 1 zur Uebertragung des mechanischen Impulses in den Tastenbereich.

Bei jeder ausreichenden Tastenbetätigung wird die Schlagvorrichtung mit vernachlässigbarer Zeitverzögerung ausgelöst, so dass der mechanische Impuls auf den noch auf der Taste liegenden Finger übertragen und taktil wahrgenommen wird. Gleichzeitig wird ein Anschlaggeräusch erzeugt.

Im beschriebenen Ausführungsbeispiel wirkt die einzige Schlagvorrichtung für alle Tastenfelder gemeinsam. Dies ist nicht störend, da in der Regel nur jeweils der betätigende Finger das Tastenfeld berührt und die Quittierung an der Berührungsstelle wahrnimmt. Es sind aber auch Ausführungen denkbar, bei welchen einzelnen Tastengruppen eigene Schlagvorrichtungen der genannten Art zugeordnet sind.

Die Spule 11 der Schlagvorrichtung ist an eine Treiberschaltung 13 angeschlossen, welche einen kurzen Stromimpuls durch die Spule 11 erzeugt. Der bewegliche Kern 10 wird dadurch in Richtung des Vorsprungs 12 angetrieben und schlägt dort auf, wodurch der mechanische Impuls erzeugt wird. Mittels der Haltefeder (nicht dargestellt) wird der Kern dann wieder in seine Ausgangslage zurückgeführt. Die Treiberschaltung 13 stellt sicher, dass die Schlagvorrichtung nur dann einen Impuls erzeugt, wenn auch ein verwertbares elektrisches Tastensignal auftritt. Zu diesem Zweck ist sie an die Interface-Schaltungen 9 für die Tasten angeschlossen. Erst wenn die Interface-Schaltung 9 ein verwertbares Signal feststellt, das einen eingestellten Spannungsschwellwert übersteigt, wird die Schlagvorrichtung 10, 11, 12 ausgelöst.

Die anhand einer speziellen Folientastatur beschriebene Vorrichtung eignet sich generell für elektronische Tastaturen ohne mechanischen Anschlag, indem sie diesen simuliert und dem Benutzer damit eine klare Quittung für einen für eine wirksame Tastenbetätigung taktil vermittelt. Insbesondere bei wegfreien Tastaturen kann damit die Eingabesicherheit wesentlich verbessert werden.

Der Schlagbolzen 10 könnte in Abänderung des beschriebenen Ausführungsbeispieles auch pneumatisch oder hydraulisch betätigt werden.

**Patentansprüche**

1. Vorrichtung an elektronischen Tastaturen zur Quittierung von Tastenbetätigungen, gekennzeichnet durch mindestens eine elektrisch auslösbare Schlagvorrichtung (10, 11, 12), welche beim Auftreten eines Tastensignals auslösbar ist und mechanisch so mit dem Tastenbereich (1) verbunden ist, dass der erzeugte mechanische Impuls auf die Tasten (2) übertragen wird.

2. Vorrichtung nach Anspruch 1, dadurch gekennzeichnet, dass die Schlagvorrichtung eine Spule (11) mit darin angeordnetem, beweglichen Kern (10) aufweist, welcher bei Speisung der Spule gegen einen mechanisch mit der Tastatur verbundenen Teil (12) schlägt.

3. Vorrichtung nach einem der vorangehenden Ansprüche, dadurch gekennzeichnet, dass die Schlagvorrichtung (10, 11, 12) elektrisch mit einer Treiberschaltung verbunden ist, die an eine Tastatur-Interfaceschaltung (13) angeschlossen ist.

4. Vorrichtung nach einem der vorangehenden Ansprüche, dadurch gekennzeichnet, dass die Tastatur wegfreie Tasten (2) aufweist.

5. Vorrichtung nach Anspruch 4, dadurch gekennzeichnet, dass die Tastatur eine Folientastatur ist.

6. Vorrichtung nach einem der vorangehenden Ansprüche, dadurch gekennzeichnet, dass die Tastatur eine mechanisch steife Frontplatte (1) mit daran ausgebildeten Tastenfeldern (2) aufweist, wobei die Schlagvorrichtung (10, 11, 12) mechanisch mit der Frontplatte (1) verbunden ist.

7. Vorrichtung nach einem der vorangehenden Ansprüche, dadurch gekennzeichnet, dass pro Tastatur nur eine Schlagvorrichtung (10, 11, 12) vorgesehen ist, welche bei jedem Tastensignal auslösbar ist.

**Claims**

1. Acknowledging device in an electronic keyboard for acknowledging the operation of keys, characterized by at least one electrically triggerable stroking device (10, 11, 12) being triggerable at the occurrence of a key signal and being mechanically connected to the key zone (1), such that the generated mechanical momentum is transmitted to said keys (2).

2. Acknowledging device according to claim 1, characterized in that the stroking device comprises of a coil (11) with a movable core (10) arranged therein, said core acting on a member (12) mechanically connected to said keyboard, when the coil is energized.

3. Acknowledging device according to one of the preceding claims, characterized in that the stroking device (10, 11, 12) is electrically connected to a driving circuit, which is connected to a keyboard interface circuit (13).

4. Acknowledging device according to one of the preceding claims, characterized in that the keyboard comprises travelless keys (2).

5. Acknowledging device according to one of the preceding claims, characterized in that the keyboard is a membrane keyboard.

6. Acknowledging device according to one of the preceding claims, characterized in that the keyboard comprises a mechanically rigid front plate (1) having key areas (2) defined thereon, wherein said stroking device (10, 11, 12) is mechanically coupled to the front plate (1).

7. Acknowledging device according to one of the preceding claims, characterized in that only one stroking device (10, 11, 12) is provided for each keyboard, wherein the stroking device (10, 11, 12) is triggerable by every key signal.

**Revendications**

1. Dispositif pour confirmer l'activation de touches sur un clavier électronique, caractérisé par au moins une unité de frappe (10, 11, 12) déclenchable par un signal induit par les touches et mécaniquement reliée au domaine (1) des touches de façon à transmettre l'impulsion mécanique à ces dernières (2).

2. Dispositif selon la revendication 1, caractérisé en ce que l'unité de frappe comprend une bobine (11) entourant un noyau mobile (10) qui vient heurter contre une partie (12) mécaniquement reliée avec le clavier lorsque la bobine est activée.

3. Dispositif selon une des revendications précédentes, caractérisé en ce que l'unité de frappe (10,11,12) est électriquement reliée avec un circuit d'entraînement connecté avec un circuit intermédiaire de clavier (13).

4. Dispositif selon une des revendications précédentes, caractérisé en ce que le clavier comporte des touches statiques (2).

5. Dispositif selon la revendication 4, caractérisé en ce que le clavier est un clavier feuilleté.

6. Dispositif selon une des revendications précédentes, caractérisé en ce que le clavier comporte une plaque frontale rigide (1) portant des domaines de touches (2), et que l'unité de frappe (10, 11, 12) est mécaniquement reliée à la plaque frontale (1).

7. Dispositif selon une des revendications précédentes, caractérisé en ce qu'il n'est prévu qu'une seule unité de frappe (10, 11, 12), par clavier, cette unité étant activable par chaque signal de touche.

Fig.1

Fig. 2

Fig.3